# EUROPÄISCHE PATENTSCHRIFT

(11) **EP 2 207 244 B1**
(45) Veröffentlichungstag und Bekanntmachung des Hinweises auf die Patenterteilung: **15.01.2014**
(21) Anmeldenummer: 09001669.2
(22) Anmeldetag: 04.02.2009
(51) Int. Cl.: H05K 1/02, H01R 12/71, H05K 3/30, H01R 12/00

(54) **Anordnung aus Steckverbinder und Multilayerplatine**
Assembly of connector and multilayer circuit board
Ensemble de connecteur à fiches et carte de circuit multicouche

(30) Priorität: 12.01.2009 DE 102009004684
(43) Veröffentlichungstag der Anmeldung: 14.07.2010
(73) Patentinhaber: ERNI Electronics GmbH & Co. KG, 73099 Adelberg (DE)
(72) Erfinder: Lappöhn, Jürgen, 73108 Gammelshausen (DE)
(74) Vertreter: Jakelski, Joachim

(56) Entgegenhaltungen:
- EP-A1- 1 049 201
- WO-A1-2005/091689
- WO-A1-2009/102415
- DE-B- 1 273 636
- US-A1- 2003 136 656
- US-A1- 2006 024 984
- US-B1- 6 776 659

## Beschreibung

Die Erfindung betrifft eine Anordnung aus einer Multilayerplatine und einem mehrpoligen Steckverbinder zur Kontaktierung mit einer Multilayerplatine nach der Gattung des unabhängigen Anspruchs.

### Stand der Technik

In der DE 699 15 882 T2 ist ein Steckverbinder beschrieben, der für eine hochfrequente Datenübertragung geeignet ist. Jedem Signal-Kontaktelement ist ein Abschirm- beziehungsweise Masse-Kontaktelement zugeordnet. Die Ausrichtung der Kontaktelemente ist derart getroffen, dass eine Impedanz-Anpassung ermöglicht wird.

In der US 6 976 886 B2 ist ein Steckverbinder beschrieben, bei dem durch eine spezielle Anordnung und/oder Ausrichtung der Signal- und Abschirm-Kontaktelemente zueinander eine hohe Abschirmwirkung der Signalleitungen gegeneinander und des Steckverbinders insgesamt erreicht werden soll. Der bekannte Steckverbinder ist speziell für hochfrequente Signale geeignet, wobei die Anordnung der Signal- und Masse-Kontaktelemente darüber hinaus zur Erzielung eines bestimmten Wellenwiderstands speziell vorgegeben ist.

Aus der US 2006/0024984 A1 ist eine Midplane-Anordnung bekannt geworden, bei der zur Verbesserung der Übertragungsqualität sogenannte "antipads" um die Kontaktdurchgänge vorgesehen sind, also Ausnehmungen in der Leiterplatte, um die Signalkontaktdurchgänge herum, um so das Signalverhalten zu verbessern. Dieses Dokument offenbart die Präambel des unabhängigen Anspruchs.

Die US 6 776 659 B1 offenbart einen Steckverbinder zur Kontaktierung mit einer Leiterplatte, der hohe Datenübertragungsraten mit hoher Geschwindigkeit ermöglicht.

Die in der DE 39 36 466 A1 beschriebene mehrpolige Hochfrequenz-Steckverbindung enthält einen Steckverbinder, der eine metallische Abschirmung aufweist, die mit zwei Kontaktelementen verbunden sind, die zur Kontaktierung mit einer Leiterplatte vorgesehen sind. Die beiden Masse-Kontaktelemente sind auf beiden Außenseiten des Steckverbinders angeordnet. Eine Zuordnung der Abschirmung zu einem ausgewählten Signal-Kontaktelement ist nicht vorgesehen.

Die DE 29 49 013 A2 beschreibt einen frequenzoptimierten Verbinder zwischen einem Koaxkabel und einer Leiterplatte. Der Mittelleiter eines Koaxkabels ist mit einem Streifenleiter verbunden, der auf einer Platine angeordnet ist. Die Abschirmung des Koaxkabels führt zu einer Massefläche, die im Bereich des Signal-Streifenleiters in zwei jeweils benachbart zum Signal-Streifenleiter angeordneten Masse-Streifenleitern aufgeteilt ist. Am anderen Ende der Platine ist ein mehrpoliger Steckverbinder auf die Platine gelötet. Ein Steckverbinder-Kontaktelement ist mit den Signal-Streifenleitern verlötet. Neben dem Signal-Kontaktelement sind vier benachbarte Kontaktelemente mit der Massefläche der Streifenleiter-Anordnung verlötet.

Die DE 39 04 461 C1 und die DE 39 36 466 A1 beschreiben mehrpolige Hochfrequenz-Steckverbinder, wobei zumindest einer der korrespondierenden Steckverbinder eine metallische Abschirmung aufweist, die mit zwei Kontaktelementen verbunden sind, welche zur Kontaktierung mit einer Leiterplatte vorgesehen sind. Die beiden Masse-Kontaktelemente sind auf beiden Außenseiten des Steckverbinders angeordnet.

In der DE 198 07 713 A1 ist ein Steckverbinder beschrieben, der eine große Anzahl von Kontaktelementen enthält. Der bekannte Steckverbinder ist zum Herstellen von Steckverbindungen zwischen Backplanes und Einschubkarten vorgesehen, wobei im konkreten Ausführungsbeispiel Steckverbindungen zwischen Backplanes und Einschubkarten sogenannter Compact-PCI-Systeme hergestellt werden.

Der Erfindung liegt die Aufgabe zugrunde, eine Anordnung aus Multilayerplatine und Steckverbinder zur Kontaktierung mit einer Multilayerplatine anzugeben, die zusammen eine gute Abschirmung bis zu hohen Frequenzen ermöglicht.

Die Aufgabe wird durch die im unabhängigen Anspruch angegebenen Merkmale gelöst.

### Offenbarung der Erfindung

Die Anordnung aus Multilayerplatine und mehrpoligem Steckverbinder zur Kontaktierung mit einer Multilayerplatine, der Signal-Kontakte aufweist, denen ein erstes und wenigstens ein zweites Abschirm-Kontaktelement zugeordnet und benachbart zum Signal-Kontakt angeordnet sind, zeichnet sich dadurch aus, dass zumindest auf der obersten Schicht der Multilayerplatine Ausnehmungen vorgesehen sind, welche zur Aufnahme und Durchführung von wenigstens zwei voneinander beabstandet angeordneten Abschirm-Kontaktelementen bemessen sind, die benachbarten Signal-Kontakten zugeordnet sind und mehrere Abschirm-Ringe miteinander verbunden sind.

Anhand von Simulationen wurde ermittelt, dass eine Aufteilung der Abschirmung auf wenigstens zwei einem Signal-Kontakt zugeordnete Abschirm-Kontaktelemente das Abschirmmaß gegenüber einem einzelnen Abschirm-Kontaktelement erheblich verbessert. Zur Anpassung der Multilayerplatine an den Steckverbinder weist die Multilayerplatine solche durchgehenden Ausnehmungen auf, die zur Aufnahme und Durchführung der wenigstens zwei Abschirm-Kontaktelemente bemessen sind. Weiterhin wird durch die Zuordnung von wenigstens zwei Abschirm-Kontaktelementen zu jeweils einem Signal-Kontakt eine ortsbezogene gleichmäßige Induktivität innerhalb des Steckverbinders und auch noch innerhalb der Multilayerplatine erzielt. Entsprechend ist der Wellenwiderstand innerhalb des Steckverbinders und der Multilayerplatine homogen verteilt.

Dadurch eignet sich insgesamt der Steckverbinder in Verbindung mit der mit dem Steckverbinder bestückten Multilayerplatine zur Führung von Signalfrequenzen bis weit in den GHz-Bereich. Die Ergebnisse der Simulationen konnten experimentell bestätigt werden.

Vorteilhafte Ausgestaltungen und Weiterbildungen des erfindungsgemäßen Steckverbinders zur Kontaktierung mit einer Multilayerplatine in Verbindung mit einer speziell ausgestalteten Multilayerplatine ergeben sich aus abhängigen Ansprüchen.

Eine Ausgestaltung sieht vor, dass der von wenigstens zwei Abschirm-Kontaktelementen abgeschirmte Signal-Kontakt ein Signal-Kontaktelementpaar enthält, das gemäß einer Weiterbildung dieser Ausgestaltung zur Führung von Differenzialsignalen beaufschlagt ist.

Eine Ausgestaltung sieht vor, dass die einem Signal-Kontakt zugeordneten Abschirm-Kontaktelemente sowie das wenigstens eine Signal-Kontaktelement des Signal-Kontakts wenigstens näherungsweise in einer Reihe und/oder Spalte des Steckverbinders nebeneinander angeordnet sind. Die geometrisch gleichmäßige Anordnung erhöht die Homogenität des Wellenwiderstands innerhalb des Steckverbinders einschließlich der mit dem Steckverbinder bestückten Multilayerplatine.

Eine weitere Ausgestaltung sieht vor, dass die Abschirm-Kontaktelemente mit einer auf einer Schicht oder mehreren Schichten der Multilayerplatine vorgesehenen Masseflächen kontaktiert sind, wobei die Masseflächen gegebenenfalls in mehrere Teilbereiche aufgeteilt sein können, um die Abschirmwirkung und/oder den Wellenwiderstand gezielt beeinflussen zu können.

Eine bevorzugte Verwendung des Steckverbinders mit der zur Kontaktierung vorgesehenen Multilayerplatine sieht vor, dass die Multilayerplatine als Backplane eingesetzt wird. Details hierzu können dem eingangs genannten Stand der Technik gemäß DE 198 07 713 A1 entnommen werden.

Eine Weiterbildung sieht vor, dass der Steckverbinder aus Segmenten zusammengesetzt ist, welche die in einer Reihe oder Spalte nebeneinander angeordneten Signal-Kontakte und Abschirm-Kontaktelemente enthalten. Die einzelnen Segmente können zumindest auf einer Seite ein Abschirmblech aufweisen. Mit diesen Maßnahmen kann der Steckverbinder einfach gefertigt werden.

Eine andere Weiterbildung sieht vor, dass die Multilayerplatine wenigstens eine einzige durchgehende Ausnehmung zur Aufnahme und Durchführung eines Signal-Kontaktelementpaars aufweist. Sofern nicht nur einzelne Ausnehmungen zur Aufnahme und Durchführung der Signal-Kontaktelementpaare, sondern derartige Ausnehmungen zur Aufnahme und Durchführung für jedes Signal-Kontaktelementpaar vorgesehen sind, kann die Multilayerplatine besonders einfach gefertigt werden.

Weitere vorteilhafte Weiterbildungen und Ausgestaltungen des zur Kontaktierung mit der Multilayerplatine vorgesehenen Steckverbinders einschließlich der Multilayerplatine ergeben sich aus den Ausführungsbeispielen und der Zeichnung der nachfolgenden Beschreibung.

### Figurenkurzbeschreibung

Figur 1 zeigt eine räumliche Ansicht eines Steckverbinders, die insbesondere einen Blick auf die zur Kontaktierung vorgesehenen Kontaktelement-Enden freigibt,
Figur 2 zeigt eine räumliche Ansicht eines korrespondierenden Steckverbinders, die ebenfalls insbesondere einen Blick auf die zur Kontaktierung vorgesehenen Kontaktelement-Enden freigibt,
Figur 3 zeigt ein Detail der in Figur 2 gezeigten Ansicht,
Figur 4 zeigt ein stark vergrößertes Detail der in Figur 2 gezeigten Ansicht,
Figur 5 zeigt ein Segment des in Figur 1 gezeigten Steckverbinders,
Figur 6 zeigt eine isometrische schematische Ansicht einer Multilayerplatine mit einer ersten Ausgestaltung von Ausnehmungen für Kontaktelemente und
Figur 7 zeigt eine isometrische schematische Ansicht einer Multilayerplatine mit einer zweiten Ausgestaltung von Ausnehmungen für Kontaktelemente.

### Detaillierte Beschreibung der Ausführungsbeispiele

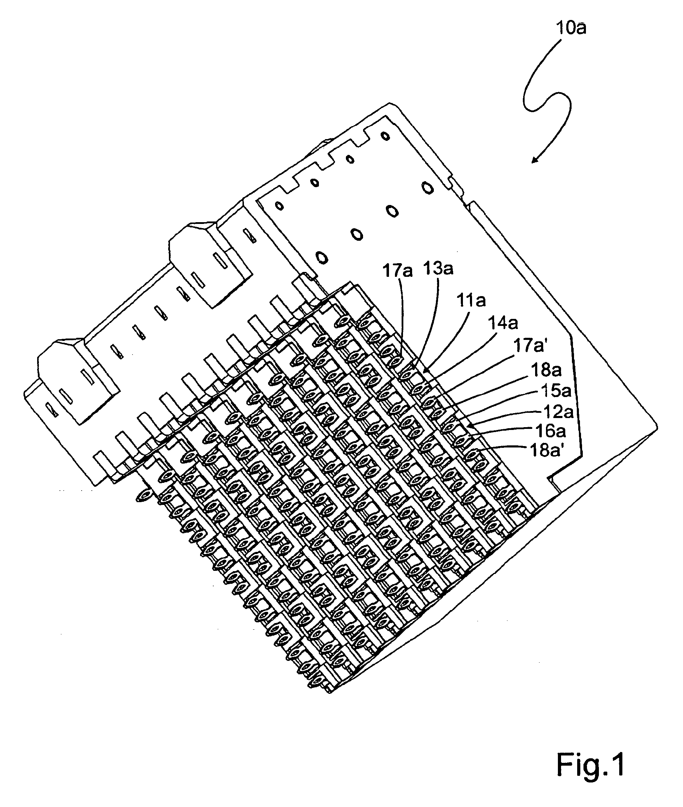

Figur 1 zeigt eine räumliche Ansicht eines mehrpoligen Steckverbinders 10a, die insbesondere einen Blick auf die zur Kontaktierung mit einer in Figur 1 nicht gezeigten Multilayerplatine vorgesehenen hinteren Enden von Kontaktelementen freigibt. In einer Reihe oder Spalte sind exemplarisch ein erster Signal-Kontakt 11a sowie ein benachbarter Signal-Kontakt 12a angeordnet. Ein Signal-Kontakt kann ein oder mehrere Signal-Kontaktelemente enthalten. Die Kontaktierung des mehrpoligen Steckverbinders 10a mit der Multilayerplatine erfolgt vorzugsweise mittels Einpresstechnik. Alternativ oder zusätzlich kann eine Verlötung vorgesehen sein.

Der erste Signal-Kontakt 11a enthält im gezeigten Ausführungsbeispiel ein erstes und zweites Signal-Kontaktelement 13a, 14a und der benachbarte Signal-Kontakt 12a ebenfalls ein erstes und zweites Signal-Kontaktelement 15a, 16a. Beide Signal-Kontakte 11a, 12a sind daher exemplarisch als Signal-Kontaktelementpaare realisiert.

Zumindest eine Auswahl von Signal-Kontakten 11a, 12a des Steckverbinders 10a soll eine Abschirmung aufweisen. Die Abschirmung wird durch Abschirm-Kontaktelement realisiert. Anstelle der Zuordnung lediglich eines einzigen Abschirm-Kontaktelements zu einem Signal-Kontakt ist eine Zuordnung eines ersten und wenigstens eines zweiten Abschirm-Kontaktelements zu den Signal-Kontakten vorgesehen. Im gezeigten Ausführungsbeispiel ist dem ersten Signal-Kontakt 11a ein erstes Abschirm-Kontaktelement 17a und wenigstens ein zweites Abschirm-Kontaktelement 17a' zugeordnet, wobei das erste Abschirm-Kontaktelement 17a auf der einen Seite des Signal-Kontakts 11 a und das andere Abschirm-Kontaktelement 17a' auf der anderen Seite des Signal-Kontakts 11a angeordnet ist, sodass der Signal-Kontakt 11 a von den ihm zugeordneten Abschirm-Kontaktelementen 17a, 17a' zumindest teilweise umgeben ist.

Dem benachbarten Signal-Kontakt 12a sind das erste Abschirm-Kontaktelement 18a sowie das wenigstens eine zweite Abschirm-Kontaktelement 18a' zugeordnet.

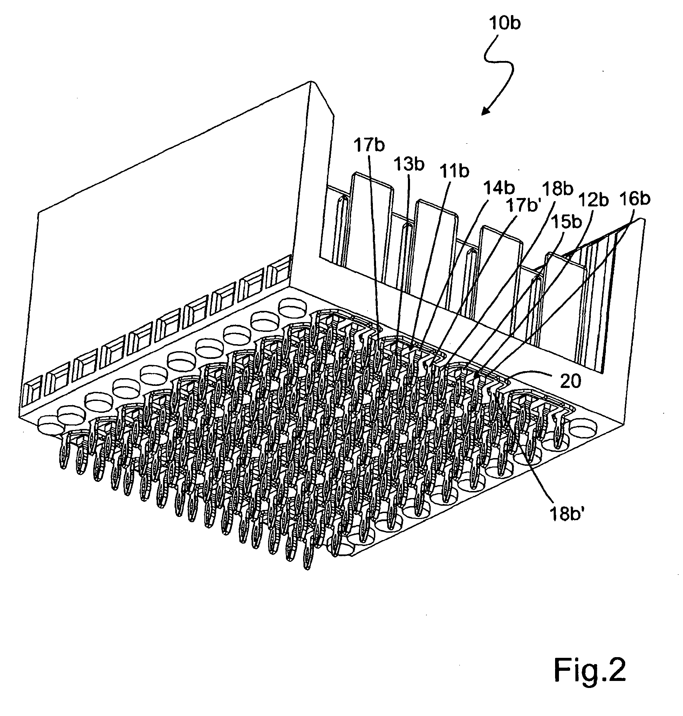

Figur 2 zeigt einen zu dem in Figur 1 gezeigten Steckverbinder 10a korrespondierenden Steckverbinder 10b. Während der in Figur 1 gezeigte Steckverbinder 10a beispielsweise Federkontakte aufweist, enthält der in Figur 2 gezeigte korrespondierende Steckverbinder 10b die korrespondierenden Messerkontakte. Diejenigen in Figur 2 gezeigten Teile, die mit den in Figur 1 gezeigten Teilen übereinstimmen, tragen jeweils dieselben Bezugszeichen, wobei als Index anstelle "a" nunmehr "b" verwendet ist. Diese Vereinbarung gilt auch für die folgenden Figuren.

Bei dem in Figur 2 gezeigten korrespondierenden Steckverbinder 10b ist eine Ausgestaltung gezeigt, die einen Abschirm-Ring 20 betrifft, welcher die Signal-Kontakte 11 b, 12b zumindest teilweise umgibt. Der Abschirm-Ring 20 ist zumindest im Bereich des hinteren, zur Kontaktierung mit der Multilayerplatine vorgesehenen Bereichs des Steckverbinders 10b vorhanden. Der Abschirm-Ring 20 kann zusätzlich oder alternativ im Innenbereich des Steckverbinders 10b vorhanden sein. Selbstverständlich kann ein derartiger Abschirm-Ring 20 auch bei dem gemäß Figur 1 ausgestalteten Steckverbinder 10a vorgesehen sein.

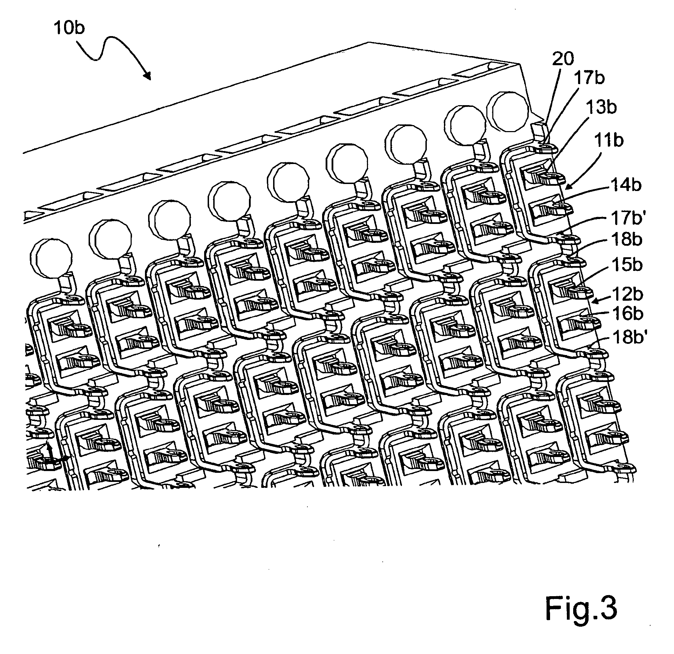

Figur 3 zeigt ein Detail der Figur 2 aus einer anderen Perspektive. Insbesondere kann Figur 3 eine weitere Ausgestaltung entnommen werden, welche vorsieht, dass der die Signal-Kontakte 11 b, 12b zumindest teilweise umgebende Abschirm-Ring 20 die dem Signal-Kontakt 11b, 12b zugeordneten Abschirm-Kontaktelemente 17b, 17b'; 18b, 18b' miteinander verbindet. Darüber hinaus ist eine weitere Ausgestaltung gezeigt, welche vorsieht, dass der Abschirm-Ring 20 die Abschirm-Kontaktelemente 17b, 17b'; 18b, 18b' mehrerer Signal-Kontakte 11b, 12b miteinander verbindet.

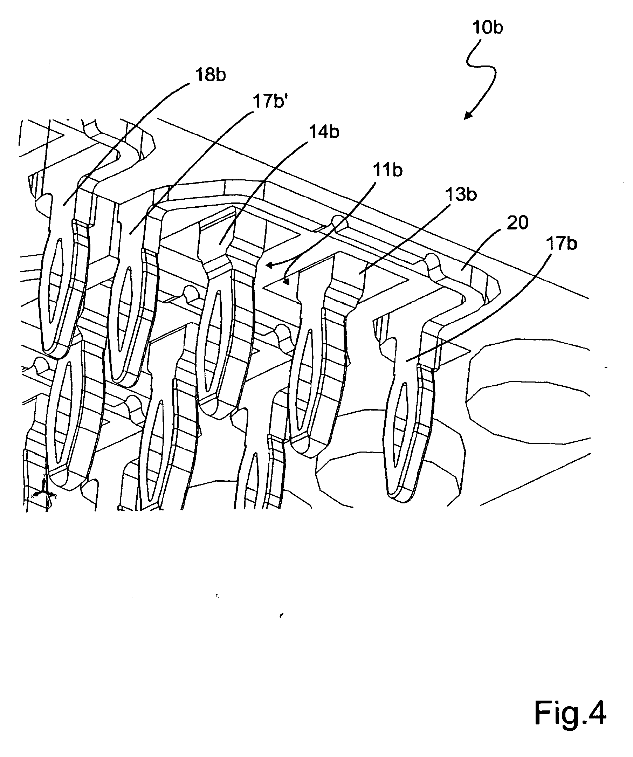

Figur 4 zeigt ein stark vergrößertes Detail der Figur 2, welches den Abschirm-Ring 20 besonders deutlich zeigt. Auch bei diesem Ausführungsbeispiel verbindet der Abschirm-Ring 20 die einem Signal-Kontakt 11 b zugeordneten Abschirm-Kontaktelemente 17b, 17b' elektrisch leitend miteinander. Darüber hinaus ist auch hier die Ausgestaltung gezeigt, dass der Abschirm-Ring 20 die Abschirm-Kontaktelemente 17b, 17b', 18b, die jeweils benachbarten Signal-Kontakten zugeordnet sind, miteinander verbindet.

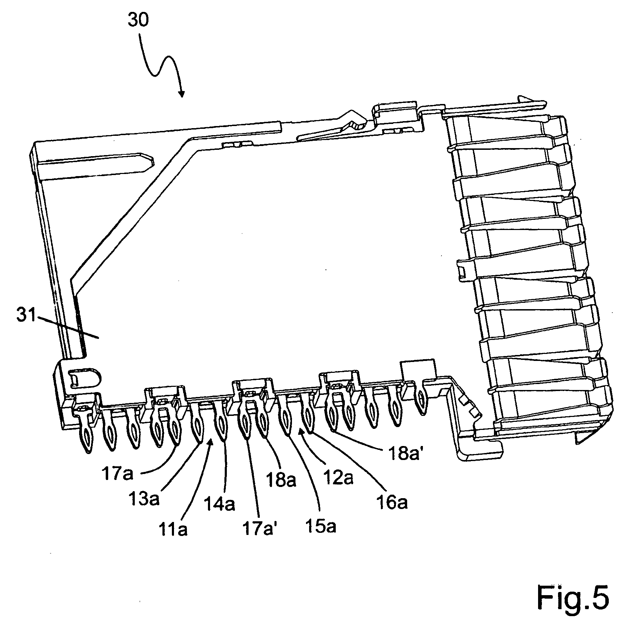

Figur 5 zeigt ein Segment 30 des in Figur 1 gezeigten Steckverbinders 10a. Aufgrund der Segmentierung kann der Steckverbinder 10a durch eine Aneinanderreihung von mehreren Segmenten 30 hergestellt werden. Damit kann die Herstellung des Steckverbinders 10a erheblich vereinfacht werden. Figur 5 zeigt ein Abschirmblech 31, welches sämtliche Kontaktelemente 13a, 13b, 14a, 14b, 15a, 15b; 16a, 16b, 17a, 17b; 17a', 17b'; 18a, 18b, 18a', 18b' überdeckt und damit gegenüber den benachbarten korrespondierenden Kontaktelementen des nächsten, nicht dargestellten Segments 30 abschirmt.

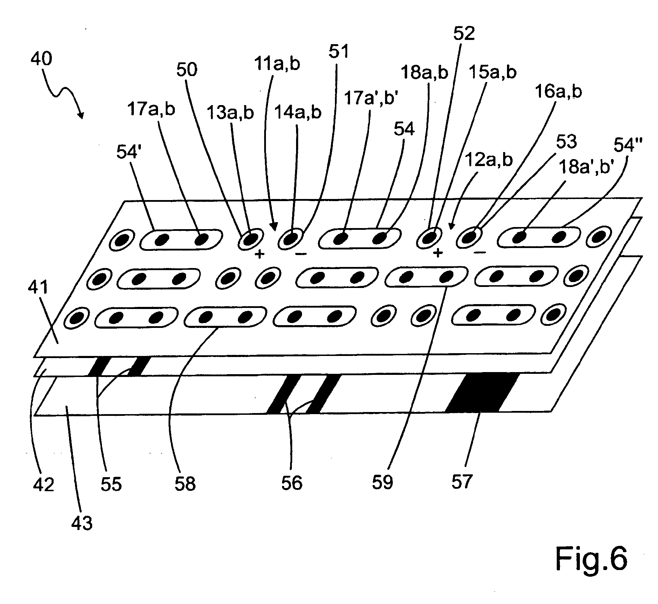

Figur 6 zeigt ein erstes Ausführungsbeispiel einer Multilayerplatine 40, die eine Mehrzahl von Schichten 41, 42, 43 aufweist. Die Multilayerplatine 40 ist zum Kontaktieren mit dem Steckverbinder 10a gemäß Figur 1 oder dem Steckverbinder 10b gemäß Figur 2 vorbereitet. Deswegen sind auch hier diejenigen Teile, die mit den in Figur 1 und 2 gezeigten Teilen jeweils übereinstimmen, mit denselben Bezugszeichen versehen. Die Darstellung gemäß Figur 6 entspricht einem Schnitt entlang der Oberfläche der obersten Schicht 41 der Multilayerplatine 40 mit dem bestückten Steckverbinder 10a, 10b.

Von den Kontaktelementen 13a, 13b, 14a, 14b; 15a, 15b, 16a, 16b; 17a, 17b, 17a', 17b'; 18a, 18b, 18a', 18b' sind deshalb nur diejenigen Teile sichtbar, welche in der Multilayerplatine 40 positioniert sind. Die Signal-Kontaktelemente 13a, 13b, 14a, 14b; 15a, 15b, 16a, 16b sind jeweils in Ausnehmungen 50, 51, 52, 53 positioniert. Erfindungsgemäß sind die Abschirm-Kontaktelemente 17a', 17b', 18a, 18b, die benachbarten Signal-Kontakten 11a, 11b; 12a, 12b zugeordnet sind, in einer einzigen durchgehenden Ausnehmung 54, 54', 54" positioniert.

Die Abschirm-Kontaktelemente 17a, 17b, 17a', 17b'; 18a, 18b, 18a', 18b' sind vorzugsweise mit Masseflächen 55, 56, 57 kontaktiert, die auf unterschiedlichen Schichten 41, 42, 43 der Multilayerplatine 40 angeordnet sein können. Die Kontaktierung erfolgt auch hier vorzugsweise mittels Einpresstechnik. Alternativ oder zusätzlich kann ein Verlöten vorgesehen sein. Die Abmessungen der Masseflächen 55, 56, 57 können in Abhängigkeit von den Erfordernissen variieren. Beispielsweise sind die auf der zweiten Schicht 42 angeordnete Massefläche 55 und die auf der untersten Schicht 42 angeordnete Massefläche 56 jeweils in mehrere Teilbereiche aufgeteilt.

Eine Ausgestaltung sieht vor, dass die beiden Signal-Kontaktelemente 13a, 13b, 14a, 14b; 15a, 15b, 16a, 16b, die jeweils einen Signal-Kontakt 11a, 11b; 12a, 12b bilden, als Differenzialkontaktpaare beschaltet sind, bei denen ein Signal-Kontaktelement 13a, 13b; 15a, 15b bezogen auf ein Bezugspotenzial einen ersten Signalverlauf führt, während das zweite Signal-Kontaktelement 14a, 14b; 16a, 16b des Signal-Kontakts 11 a, 11 b; 12a, 12b einen invertierten Signalverlauf führt. Zur Verdeutlichung ist das eine Signal-Kontaktelement 13a, 13b; 15a, 15b mit einem Plus-Symbol und das andere Signal-Kontaktelement 14a, 14b; 16a, 16b mit einem Minus-Symbol beschriftet.

Figur 6 zeigt eine weitere Ausgestaltung, gemäß der vorgesehen ist, dass die beiden Signal-Kontaktelemente 13a, 13b, 14a, 14b; 15a, 15b, 16a, 16b von zumindest einzelnen Signal-Kontakten 11a, 11b; 12a, 12b ebenfalls in einer durchgehenden Ausnehmung 58, 59 angeordnet sind.

Die Ausnehmungen 54, 54', 54", 58, 59 sind zumindest in der obersten Schicht 41 der Multilayerplatine 40 und bedarfsweise auch in darunter liegenden Schichten 42, 43 vorgesehen.

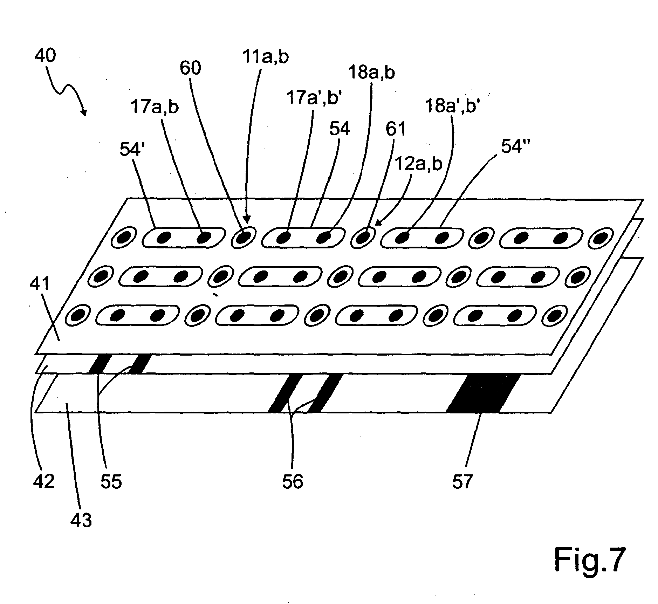

Figur 7 zeigt ein weiteres Ausführungsbeispiel der Multilayerplatine 40, die ebenfalls eine Mehrzahl von Schichten 41, 42, 43 aufweist. Die Multilayerplatine 40 ist zur Kontaktierung mit einer Ausgestaltung des Steckverbinders 10a, 10b vorgesehen, bei welcher der Signal-Kontakt 11a, 11 b; 12a, 12b lediglich jeweils ein einziges Signal-Kontaktelement 60, 61 aufweist. Die weiteren Ausgestaltungen können entsprechend der in Figur 6 gezeigten Multilayerplatine 40 vorgesehen sein.

Prinzipiell ist es bei erhöhtem Fertigungsaufwand möglich, den Steckverbinder 10a, 10b und die zur Kontaktierung vorgesehene Multilayerplatine 40 derart auszugestalten, dass ein Teil der Signal-Kontaktelemente 13a, 13b, 14a, 14b; 15a, 15b, 16a, 16b der Signal-Kontakte 11 a, 11 b; 12a, 12b lediglich ein einziges Signal-Kontaktelement 60, 61 und ein anderer Teil der Signal-Kontaktelemente 11a, 11 b; 12a, 12b Signal-Kontaktelementpaare 13a, 13b, 14a, 14b; 15a, 15b, 16a, 16b aufweisen.

## Patentansprüche

1. Anordnung aus Multilayerplatine und mehrpoligem Steckverbinder zur Kontaktierung mit einer Multilayerplatine (40), der Signal-Kontakte (11a, 11b; 12a, 12b) aufweist, denen ein erstes und wenigstens ein zweites Abschirm-Kontaktelement (17a, 17b, 17a', 17b'; 18a, 18b, 18a', 18b') zugeordnet und benachbart zum Signal-Kontakt (11 a, 11 b; 12a, 12b) angeordnet sind, und zumindest in dem zur Kontaktierung vorgesehenen Bereich der Kontaktelemente (13a, 13b, 14a, 14b; 15a, 15b, 16a, 16b, 17a, 17b, 17a', 17b'; 18a, 18b, 18a', 18b'; 60; 61) ein elektrisch leitender Abschirm-Ring (20) vorgesehen ist, der den abzuschirmenden Signal-Kontakt (11 a, 11 b; 12a, 12b) zumindest teilweise umschließt, so dass der Abschirm-Ring (20) das erste und zweite Abschirm-Kontaktelement (17a, 17b, 17a', 17b'; 18a, 18b, 18a', 18b') kontaktiert, wobei zumindest auf der obersten Schicht (41) der Multilayerplatine (40) Ausnehmungen (54, 54', 54") vorgesehen sind, **dadurch gekennzeichnet, dass** die Ausnehmungen zur Aufnahme und Durchführung von wenigstens zwei voneinander beabstandet angeordneten Abschirm-Kontaktelementen (17a', 17b'; 18a, 18b) bemessen sind, die benachbarten Signal-Kontakten (11a, 11 b; 12a, 12b) zugeordnet sind, und dass mehrere Abschirm-Ringe (20) miteinander verbunden sind.

2. Anordnung nach Anspruch 1, **dadurch gekennzeichnet, dass** der von wenigstens zwei Abschirm-Kontaktelementen (17a, 17b, 17a', 17b'; 18a, 18b, 18a', 18b') abgeschirmte Signal-Kontakt (11a, 11b; 12a, 12b) ein Signal-Kontaktelementpaar (13a, 13b, 14a, 14b; 15a, 15b, 16a, 16b) enthält.

3. Anordnung nach Anspruch 1, **dadurch gekennzeichnet, dass** die einem Signal-Kontakt (11a, 11 b; 12a, 12b) zugeordneten Abschirm-Kontaktelemente (17a, 17b, 17a', 17b'; 18a, 18b, 18a', 18b') sowie das wenigstens eine Signal-Kontaktelement (13a, 13b, 14a, 14b; 15a, 15b, 16a, 16b; 60; 61) des Signal-Kontakts (11 a, 11 b; 12a, 12b) wenigstens näherungsweise in einer Reihe und/oder Spalte des Steckverbinders (10a, 10b) nebeneinander angeordnet sind.

4. Anordnung nach Anspruch 1, **dadurch gekennzeichnet, dass** die Abschirm-Kontaktelemente (17a, 17b, 17a', 17b'; 18a, 18b, 18a', 18b') mit einer auf einer Schicht (41, 43, 43) der Multilayerplatine (40) vorgesehenen Massefläche (55, 56, 57) kontaktiert sind.

5. Anordnung nach Anspruch 1, **dadurch gekennzeichnet, dass** der Steckverbinder (10a, 10b) mit einer Multilayerplatine (40) kontaktiert ist, die als Backplane eingesetzt ist.

6. Anordnung nach Anspruch 1, **dadurch gekennzeichnet, dass** die Signal-Kontaktelementpaare (13a, 13b, 14a, 14b; 15a, 15b, 16a, 16b) Differenzsignale führen.

7. Anordnung nach Anspruch 3, **dadurch gekennzeichnet, dass** der Steckverbinder (10a) aus Segmenten (30) zusammengesetzt ist, welche die in einer Reihe oder Spalte nebeneinander angeordneten Signal-Kontakte (11a, 11b; 12a, 12b) und Abschirm-Kontaktelemente (17a, 17b, 17a', 17b'; 18a, 18b, 18a', 18b') enthalten.

8. Anordnung nach Anspruch 7, **dadurch gekennzeichnet, dass** die Segmente (30) zumindest auf einer Seite ein Abschirmblech (31) aufweisen.

9. Anordnung nach Anspruch 1, **dadurch gekennzeichnet, dass** die Multilayerplatine (40) eine durchgehende Ausnehmung (58, 59) jeweils zur Aufnahme und Durchführung von zumindest einzelnen Signal-Kontaktelementpaaren (13a, 13b, 14a, 14b; 15a, 15b, 16a, 16b) aufweist.

## Claims

1. An assembly of a multilayer circuit board and a multi-polar plug connector having signal contacts (11 a, 11 b; 12a, 12b) for establishing contact with a multilayer circuit board (40), said signal contacts being associated with a first and at least one second screen contact element (17a, 17b, 17a', 17b'; 18a, 18b, 18a', 18b') and being arranged adjacent to the signal contact (11 a, 11 b; 12a, 12b), and an electrically conductive screen ring (20) is provided at least in the region of the contact elements (13a, 13b, 14a, 14b; 15a, 15b, 16a, 16b, 17a, 17b, 17a', 17b'; 18a, 18b, 18a', 18b'; 60; 61) provided for establishing contact, said conductive screen ring (20) enclosing the signal contact (11 a, 11 b; 12a, 12b) at least in part, so that the screen ring (20) makes contact with the first and second contact element (17a, 17b, 17a', 17b'; 18a, 18b, 18a', 18b'), wherein recesses (54, 54', 54") are provided at least on the uppermost layer (41) of the multilayer circuit board (40), **characterized in that** the recesses are dimensioned for accommodating and leading through at least two screen contact elements (17a', 17b'; 18a, 18b) which are arranged to be spaced from each other and are associated with adjacent signal contacts (11 a, 11 b; 12a, 12b), and that several screen rings (20) are connected to each other.

2. An assembly according to claim 1, **characterized in that** the signal contact (11 a, 11 b; 12a, 12b) screened by at least two screen contact elements (17a, 17b, 17a', 17b'; 18a, 18b, 18a', 18b') contains a pair of signal contact elements (13a, 13b, 14a, 14b; 15a, 15b, 16a, 16b).

3. An assembly according to claim 1, **characterized in that** the screen contact elements (17a, 17b, 17a', 17b'; 18a, 18b, 18a', 18b') associated with a signal contact (11a, 11b; 12a, 12b) and the at least one signal contact element (13a, 13b, 14a, 14b; 15a, 15b, 16a, 16b; 60; 61) of the signal contact (11a, 11b; 12a, 12b) are arranged adjacent to one another at least approximately in a row and/or column of the plug connector (10a, 10b).

4. An assembly according to claim 1, **characterized in that** the screen contact elements (17a, 17b, 17a', 17b'; 18a, 18b, 18a', 18b') make contact with a ground area (55, 56, 57) provided on a layer (41, 43, 43) of the multilayer circuit board (40).

5. An assembly according to claim 1, **characterized in that** the plug connector (10a, 10b) establishes contact with a multilayer circuit board (40) which is used as a backplane.

6. An assembly according to claim 1, **characterized in that** the pairs of signal contact elements (13a, 13b, 14a, 14b; 15a, 15b, 16a, 16b) conduct differential signals.

7. An assembly according to claim 3, **characterized in that** the plug connector (10a) is composed of segments (30) which contain the signal contacts (11 a, 11 b; 12a, 12b) and the screen contract elements (17a, 17b, 17a', 17b'; 18a, 18b, 18a', 18b') which are arranged in a row or column adjacent to one another.

8. An assembly according to claim 7, **characterized in that** the segments (30) comprise a screening plate (31) on at least one side.

9. An assembly according to claim 1, **characterized in that** the multilayer circuit board (40) comprises a continuous recess (58, 59) for respectively accommodating and leading through at least individual pairs of signal contact elements (13a, 13b, 14a, 14b; 15a, 15b, 16a, 16b).

## Revendications

1. Ensemble constitué par une carte de circuit imprimé multicouche et un connecteur à fiches multipolaire pour permettre sa mise en contact avec une carte de circuit imprimé multicouche (40) qui comporte des contacts de signal (11a, 11b ; 12a, 12b) auxquels sont associés un premier et au moins un second élément de contact de blindage (17a, 17b, 17a', 17b' ; 18a, 18b, 18a', 18b') situés au voisinage du contact de signal (11a, 11b ; 12a, 12b), et au moins dans la zone des éléments de contact (13a, 13b ; 14a, 14b ; 15a, 15b ; 16a, 16b ; 17a, 17b, 17a', 17b'; 18a, 18b, 18a', 18b'; 60 ; 61) prévue pour la mise en contact d'une bague de blindage électriquement conductrice (1) qui entoure au moins partiellement le signal de contact (11a, 11b ; 12a, 12b) à blinder, de sorte que la bague de blindage (10) vienne en contact avec le premier et le second élément de blindage (17a, 17b, 17a', 17b' ; 18a, 18b, 18a', 18b'), au moins sur la couche supérieure (41) de la carte de circuit imprimé multicouche (40) étant prévus des évidements (54, 54', 54"),
**caractérisé en ce que**
les évidements sont dimensionnés pour permettre la réception et la traversée d'au moins deux éléments de contact de blindage (17a', 17b'; 18a, 18b) situés à distance l'un de l'autre qui sont associés aux contacts de signaux voisins (11a, 11b, 12a, 12b), et
plusieurs bagues de blindage (20) sont reliées entre elles.

2. Ensemble conforme à la revendication 1,
**caractérisé en ce que**
le contact de signal (11a, 11b, 12a, 12b) blindé par au moins deux éléments de contact de blindage (17a, 17b, 17a', 17b'; 18a, 18b, 18a', 18b') renferme une paire d'éléments de contact de signal (13a, 13b ; 14a, 14b ; 15a, 15b ; 16a, 16b).

3. Ensemble conforme à la revendication 1,
**caractérisé en ce que**
les éléments de contact de blindage (17a, 17b, 17a', 17b' ; 18 a, 18b, 18a', 18b') associés à un contact de signal (11a, 11b, 12a, 12b) ainsi que l'élément de contact de signal (13a, 13b ; 14a, 14b ; 15a, 15b ; 16a, 16b ; 60 ; 61) du contact de signal (11a, 11b, 12a, 12b) sont positionnés au voisinage les uns des autres au moins approximativement en une rangée ou en une colonne du connecteur à fiches (10a, 10b).

4. Ensemble conforme à la revendication 1,
**caractérisé en ce que**
les éléments de contact de blindage (17a, 17b, 17a', 17b'; 18a, 18b, 18a', 18b') sont en contact avec une surface de masse (55, 56, 57) prévue sur une couche (41, 43, 43) de la carte de circuit imprimé multicouche (40).

5. Ensemble conforme à la revendication 1,
**caractérisé en ce que**
le connecteur à fiches (10a, 10b) est en contact avec une carte de circuit imprimé multicouche (40) qui est réalisée sous la forme d'un socle.

6. Ensemble conforme à la revendication 1,
**caractérisé en ce que**
les paires d'éléments de contact de signal (13a, 13b ; 14a, 14b ; 15a, 15b ; 16a, 16b) transfèrent des signaux différentiels.

7. Ensemble conforme à la revendication 3,
**caractérisé en ce que**
le connecteur à fiches (10a) est constitué par l'assemblage de segments (30) qui renferment les contacts de signal (11a, 11b, 12a, 12b) positionnés côte à côte en une rangée ou en une colonne et des éléments de contact de blindage (17a, 17b, 17a', 17b' ; 18a, 18b, 18a', 18b').

8. Ensemble conforme à la revendication 7,
**caractérisé en ce que**
les segments (30) comportent au moins d'un côté une tôle de blindage (31).

9. Ensemble conforme à la revendication 1,
**caractérisé en ce que**
la carte de circuit multicouche (40) comporte un évidement traversant (58, 59) respectivement pour permettre la réception et la traversée d'au moins des paires d'éléments de contact de signal individuelles (13a, 13b, 14a, 14b ; 15a, 15b ; 16a, 16b).
